# EUROPEAN PATENT APPLICATION

(11) **EP 1 852 372 A1**
(43) Date of publication of application: **07.11.2007**
(21) Application number: 06713644.0
(22) Date of filing: 14.02.2006
(51) Int. Cl.: B65G 27/02, B65G 47/14, C23C 14/24

(54) **VIBRATING BOWL, VIBRATING BOWL FEEDER, AND VACUUM DEPOSITION APPARATUS**

(30) Priority: 25.02.2005 JP 2005051445
(71) Applicant: Shinmaywa Industries, Ltd., Takarazuka-shi, Hyogo 665-8550 (JP)
(72) Inventor: OGAWA, Kenichi c/o Research and Development Centre,, Takarazuka-shi, Hyogo 665-8550 (JP); OKADA, Motoi c/o Research and Development Centre,, Takarazuka-shi, Hyogo 665-8550 (JP); YAMAKAWA, Kenji c/o Research and Development Centre,, Takarazuka-shi, Hyogo 665-8550 (JP); Takeuchi, Kiyoshi c/o Research and Development Centre,, Takarazuka-shi, Hyogo 665-8550 (JP)
(74) Representative: Piésold, Alexander James
(86) International application number: PCT/JP2006/302503
(87) International publication number: WO 2006/090608

(57) **Abstract**

A vibrating bowl and the like are provided which are capable of accurately counting the number of objects to be fed. The vibrating bowl (10) includes: a concave portion (10a) capable of storing therein collectivity of objects (15) to be fed; a feed passage (20) capable of feeding the objects (15) within the concave portion (10a) by vibrating the objects (15); and a step portion (26) configured to cause the objects to be ejected outside of the concave portion (10a) in a direction substantially perpendicular and downwardly oblique to a feed direction in which those objects (15) which are present in the vicinity of a termination of the feed passage (20) are fed.

## Description

### Technical Field

The present invention relates to a vibrating bowl, a vibrating bowl feeder and a vacuum deposition system (hereinafter will be generally referred to as "vibrating bowl and the like"). More specifically, the invention relates to improvements in the object feeding technique for ejecting objects to be fed to outside by vibrating the objects.

### Background Art

A vibrating feeding system configured to align various kinds of objects to be fed, such as electronic components and precision machine parts, in a fixed direction automatically by utilizing vibration exerted on the objects and then feed a fixed number or amount of such objects to the next manufacturing process step, is well known.

For example, a parts detecting device (comprising a light-emitting device and a photoelectric converter) has been disclosed which is capable of detecting the number of supplied parts ejected from a bowl vibrated by a vibrating section at an intermediate point on a chute (see patent document 1 as a conventional technique).

Also, a deposition material feeding device wherein: a bowl feeder (bowl) to be vibrated by a vibrator is formed with a helical groove on a peripheral surface thereof; and vibration of the vibrator causes deposition materials located inside the bowl feeder to be fed to a deposition material exit by passage through the helical groove, has been developed (see patent document 2 as a conventional technique).

Another disclosed conventional technique is a method of controlling a parts feeder provided with vibration detecting means capable of detecting signals obtained from a piezoelectric vibrator for vibrating a vibrating device, the method enabling a control section to control a power amplifier driving the piezoelectric vibrator based on feedback signals obtained from the vibration detecting means (see patent document 3 as a conventional technique).

Also, a work feeding device has been developed which is capable of automatically actuating or stopping a work delivery device (vibratory hopper) by means of a proximity sensor configured to detect movement of a detecting rod rocking in accordance with the quantity of remaining works passing below the detecting rod (see patent document 4 as a conventional technique).

A parts feeder has been proposed which includes: a bowl configured to feed multiple works aligned on a feed track formed along the inner periphery of the bowl by vibrating the works; a vibrating section for applying the bowl with a work feeding vibration determined from the voltage, frequency and the like essential to an electric power used; a sensor mounted at the exit of the feed track for detecting the number of works passing through the exit and outputting an electric signal indicative of the number detected; and an electric control section configured to control power supply to the vibrating section in accordance with the signal inputted from the sensor thereby to control the number of works to pass through the exit (see patent document 5 as a conventional technique).

A time-lagged mercury switch for controlling the opening/closing operation of a replenishing tank configured to replenish a hopper with parts and/or the operation of feeding parts to a trough in order to keep the total number of parts within the hopper substantially constant is also known (see patent document 6 as a conventional technique).

Further, a vibrating parts feeder has been disclosed which has a track provided with a tier collapsing groove for aligning parts collected in plural tiers or rows in feeding such collectivity of parts on the track by vibrating the collectivity of parts (see patent document 7 as a conventional technique).
Patent document 1: Japanese Patent Laid-Open Publication No. HEI 6-72532
Patent document 2: Japanese Patent Laid-Open Publication No. 2003-321768
Patent document 3: Japanese Patent Laid-Open Publication No. 2003-48614
Patent document 4: Japanese Utility Model Laid-Open Publication No. HEI 6-6325
Patent document 5: Japanese Utility Model Laid-Open Publication No. SHO 60-173517
Patent document 6: Japanese Utility Model Laid-Open Publication No. SHO 59-88019
Patent document 7: Japanese Patent Laid-Open Publication No. HEI 10-181850

### Disclosure of Invention

### Problem to be solved by Invention

Under the circumstances where a predetermined number (for example 10) of granular metal balls (diameter: about 1.5 mm) are to be fed accurately to an evaporating site for the metal balls to be subjected to vapor deposition within a vacuum chamber of a vacuum deposition system, the inventors of the present invention think that the aforementioned conventional object feeding techniques are far from paying adequate attention to the following problems.

The problems associated with the conventional object feeding techniques disclosed in the above patent documents will be described with appropriate comparison between these techniques.

Firstly, any one of the conventional object feeding techniques described in the above patent documents has poor recognition of a technical challenge to provide number detecting means for accurately counting the number of objects (for example metal balls to be fed to an evaporating site) ejected from a vibrating bowl.

The parts feeder described in patent document 1 or 5 apparently has a sensor analogous to such number detecting means.

However, the parts detecting device described in patent document 1 is located at an intermediate point on a chute far apart from the exit of the parts feeder and, hence, it is highly possible that a difference in number occurs between the total number of parts ejected from the exit of the parts feeder during a predetermined time period and the total number of parts determined from data obtained by the parts detecting device during the same time period, due to a time lag from a point in time at which each part is ejected from the exit to a point in time at which the part reaches the parts detecting device. For this reason, the detection technique described in patent document 1 is unsuitable as a number detecting technique intended for accurate counting of the total number of metal balls to be fed to the evaporating site.

In contrast, the optical sensor described in patent document 5 is mounted in the vicinity of the exit of the feed track, but the portion of the feed track at which the optical sensor is mounted extends horizontally. For this reason, works collected into collectivity are fed on the feed track at a time, which may cause the optical sensor to make an error in detecting the number of works. Therefore, the detection technique described in patent document 5 is also unsuitable as a number detecting technique intended for accurate counting of the total number of metal balls to be fed to the evaporating site.

Secondly, each of the conventional object feeding techniques described in the above patent documents adopts a tangentially ejecting technique such that the ejecting exit for ejecting objects to outside is oriented in the same direction as the object feed direction. This makes it difficult to lead objects (for example granular metal balls) one by one to an outside place (for example a chute portion for guiding metal balls or an evaporating site connected to the chute portion) accurately per unit time.

Referring to a problem associated with the tangentially ejecting technique of the vibrating bowl feeder described in patent document 6 for example, when parts are consecutively ejected from the vibrating bowl feeder in the tangential direction, some positioning of a trough (for example, horizontally positioning of the trough) may cause a plurality of such parts to be fed in a condition rendered contiguous with each other through the trough or a feed passage located downstream of the trough. This may cause the number detecting-means to become unable to detect the number of parts ejected outside of the vibrating bowl feeder reliably.

Referring, to a problem associated with the tangentially ejecting technique described in patent document 5 from a different point of view, the moving speed of works on a chute extending from the exit of the feed track tangentially to the bowl changes with variations in the work feeding ability of the bowl. Accordingly, when the work feeding ability differs from a set value, the moving speed of works on the chute varies, which makes it difficult to control the number of works passing through the chute per unit time.

Thirdly, even with the conventional object feeding techniques of the above patent documents taken into consideration, it is difficult to realize simple alignment means capable of aligning collectivity of objects into a single row or tier at an intermediate point on the feed passage.

Patent document 7 of the above patent documents is directed to the vibrating parts feeder including an arrangement for aligning rectangular parts into a single row and tier (for example the tier collapsing groove formed on the track). However, the inventors of the present invention believe that in cases where the objects to be fed are each a simple object having a symmetrical shape such as a metal ball, simple alignment means can be realized which exhibits an effect similar to the effect of the tier collapsing groove of patent document 7 without need to groove the track intricately.

The present invention has been made in view of the foregoing circumstances. A first object of the present invention is to provide a vibrating bowl and the like which are capable of accurately counting objects to be fed.

A second object of the present invention is to provide a vibrating bowl and the like which are capable of accurately leading objects one by one to an external place per unit time.

A third object of the present invention is to provide a vibrating bowl and the like which are capable of aligning collectivity of objects into a row or tier at an intermediate point on a feed passage by simple alignment means.

### Means for solving Problem

In order to attain the foregoing objects, a vibrating bowl according to the present invention comprises: a concave portion capable of storing therein collectivity of objects to be fed; a feed passage capable of feeding the objects within the concave portion by vibrating the objects; and a step portion configured to cause the objects to be ejected outside of the concave portion in a direction substantially perpendicular and downwardly oblique to a feed direction in which the objects which are present in the vicinity of a termination of the feed passage are fed.

Here, the aforementioned step portion has a cut slope formed by cutting out a portion of the feed passage widthwise and downwardly.

The step thus formed realizes a perpendicularly ejecting technique for ejecting the objects outside of the concave portion in the direction perpendicular to the feed direction in which those objects which are present in the vicinity of the termination of the feed passage are fed. With this perpendicularly ejecting technique employed, even under the condition that the objects are fed contiguously with each other, the object feed direction is changed to a direction substantially perpendicular thereto by the step portion and such a change in the feed direction provides appropriate spacing between adjacent ones of the objects passing through the step portion. For this reason, it is possible to avoid plural objects being fed in a condition rendered contiguous with each other through the step portion and through a feed passage extending downstream of the step portion and, hence, number detecting means becomes capable of reliably detecting the number of objects ejected outside of the vibrating bowl.

Even when the object vibrating and feeding ability of the vibrating bowl differs from a set value, the moving speed of each object passing through the step portion is determined from the angle of inclination of the cut slope inclined downwardly and the object's own weight, which makes it easy to control the number of objects passing through the step portion per unit time.

Another vibrating bowl according to the present invention comprises: a concave portion capable of storing therein collectivity of objects to be fed; a feed passage capable of feeding the objects within the concave portion by vibrating the objects; and a step portion configured to cause the objects which are present in the vicinity of a termination of the feed passage to be ejected outside of the concave portion in a downwardly oblique direction; and number detecting means facing the step portion for counting a number of the objects which are being fed on the step portion.

Here, it is possible that the aforementioned step portion has a cut slope formed by cutting out a portion of the feed passage widthwise and downwardly, and the aforementioned number detecting means has a detection window facing the cut slope.

When each of the objects is substantially spherical, the aforementioned cut slope may have a width larger than a diameter of each object and smaller than a value twice as large as the diameter of each object. This feature makes it possible to prevent a nonconforming object comprising plural objects joined to each other or an elongate impurity from entering an object ejecting passage advantageously.

With such number detecting means, it is possible to count the number of objects ejected outside of the concave portion of the vibrating bowl accurately.

Yet another vibrating bowl according to the present invention comprises: a concave portion capable of storing therein collectivity of objects to be fed; a feed passage capable of feeding the objects within the concave portion by vibrating the objects; and a cutout groove for aligning plural rows of collected objects that are present at an intermediate point on the feed passage into a single row widthwise of the feed passage, the cutout groove being formed by cutting out a portion of the feed passage widthwise to leave a remaining portion having a predetermined width.

When each of the objects is substantially spherical, the aforementioned predetermined width may be substantially equal to a diameter of each object. The aforementioned cutout groove is desirably located adjacent to a termination of the feed passage.

. Yet another vibrating bowl according to the present invention comprises: a concave portion capable of storing therein collectivity of objects to be fed; a feed passage capable of feeding the objects within the concave portion by vibrating the objects; and a fragment member extending upwardly from a location spaced a predetermined distance apart from a feed surface of the feed passage as a reference surface, for aligning plural tiers of collected objects that are present at an intermediate point on the feed passage into a single tier.

When each of the objects is substantially spherical, the aforementioned predetermined distance may be larger than a diameter of each object and smaller than a value twice as large as the diameter of each object.

The cutout groove and the fragment member are each capable of exercising an object aligning effect such as to easily align objects that are present at an intermediate point on the feed passage into a single row or tier. Accordingly, the objects can be ejected one by one through a zone coinciding with the detection window of the number detecting means reliably. Thus, the number detection means, in cooperation with the cutout groove or fragment member exercising the object aligning effect, can detect the number of objects ejected outside of the concave portion reliably without a number detection error.

The concave portion may have an inner wall provided with a predetermined marking for allowing the total number of collected objects stored in the concave portion to be checked easily.

A vibrating bowl feeder according to the present invention is a device comprising a vibrator supporting any one of the vibrating bowls described above for vibrating the vibrating bowl, wherein the objects on the feed passage are capable of being fed by vibration of the vibrating bowl caused by the vibrator.

The concave portion may be provided with a reticulate member covering an opening of the concave portion.

The reticulate member can appropriately sift objects to prevent a metal ball having a nonconforming size or metal mass comprising plural metal balls joined fixedly to each other from entering the concave portion.

The vibrating bowl feeder may be a device further comprising: a hopper located above the opening of the concave portion of the vibrating bowl for reserving collectivity of objects therein; a level detecting means for detecting an uppermost height level of the collectivity of objects stored in the concave portion; and a control device configured to control an object supply operation of the hopper based on position data obtained from the level detecting means so as to adjust supply of the objects from the hopper to the concave portion.

The control device of the vibrating bowl feeder is capable of appropriately adjusting the supply operation of the hopper based on position data on the uppermost height level of the collectivity of objects stored in the concave portion which is obtained by the level detecting means. For example, the control device may be configured to control opening/closing timing for the object supply door of the hopper by means of a hopper driving device while monitoring the quantity of the collected objects, thereby adjusting the object supply from the hopper to the concave portion appropriately.

The vibrating bowl feeder may be a device comprising: a vibrator supporting any one of the vibrating bowls described above for vibrating the vibrating bowl; number detecting means configured to count a number of objects being fed on the step portion; and a control device capable of controlling a frequency or amplitude of a vibration signal to be fed to the vibrator based on number data obtained by the number detecting means so as to adjust an object vibrating and feeding ability of the vibrating bowl. This arrangement is preferable because the control device controls the frequency or amplitude of the signal so as to keep a number of objects fed per unit time based on data obtained by the number detecting means.

A vacuum deposition system according to the present invention comprises: a vacuum chamber of which internal pressure is reducible; any one of the vibrating bowl feeders described above which is located inside the vacuum chamber; a vessel capable of being loaded with objects ejected outside from the bowl feeder as a film forming material; and heating means capable of heating the film forming material comprising the objects, wherein the film forming material is heated by heating means and is vapor-deposited on a substrate placed inside the vacuum chamber under a reduced internal pressure.
This vacuum deposition system allows the vibrating bowl feeder to supply the vessel with a predetermined number of objects serving as the film forming material to be evaporated within the vacuum chamber accurately. Accordingly, appropriate control over the weight or volume per object will make it possible to control the thickness of the film vapor-deposited over the surface of the substrate in the vacuum deposition system easily and precisely. Also, the vacuum deposition system is capable of easily varying the total number of objects to be supplied to the vessel, hence, quickly responding to a change in the thickness of a deposited film required for a product to be subjected to vapor deposition by the vacuum deposition system.

The foregoing and other objects, features and attendant advantages of the present invention will become more apparent from the reading of the following detailed description of the preferred embodiments in conjunction with the accompanying drawings. Advantage of Invention

According to the present invention, it is possible to provide a vibrating bowl and the like which are capable of accurately counting the number of objects to be fed.

According to the present invention, it is also possible to provide a vibrating bowl and the like which are capable of accurately leading objects one by one to an external place.
Further, according to the present invention, it is possible to provide a vibrating bowl and the like which are capable of aligning collectivity of objects into a single row or tier at an intermediate point on a feed passage by simple alignment means.

### Brief Description of Drawings

[FIG. 1] FIG. 1 is a schematic illustration showing the configuration of a vibrating bowl feeder according to an embodiment of the present invention.
[FIG. 2] FIG. 2 is a view illustrating an internal structure of a vibrating bowl.
[FIG. 3] FIG. 3 is a view illustrating an internal structure of a vibrating bowl.
[FIG. 4] FIG. 4 is a view illustrating an internal structure of a vibrating bowl.
[FIG. 5] FIG. 5 is a view illustrating an internal structure of a vibrating bowl.
[FIG. 6] FIG. 6 is a schematic illustration showing an internal structure of a vacuum deposition system according to an embodiment of the present invention.
[FIG. 7] FIG. 7 is a view illustrating a variation of the embodiment.

### Description of Reference Characters

10...vibrating bowl
10a...concave portion
10b...step
10c...bottom surface
10d...side surface
11...vibrator
12...guide member
13...reticulate member
14...hopper
15...objects to be fed (metal balls)
16a...first optical sensor
16b....second optical sensor
17...hopper driving device
18...frequency/amplitude varying circuit
19...control device
20...feed passage
21...through-hole
22...cutout groove
23...fragment member
24...rim ridge
25...bolt
26...step portion
26a...cut slope
26b...slanting surface
30...vacuum chamber
31...vessel
32...chute portion
33...turret
34...evaporating site
50...vibrating bowl feeder
100...vacuum deposition system

### Best Mode for Carrying Out the Invention

Hereinafter, preferred embodiments of the present invention will be described with reference to the drawings.

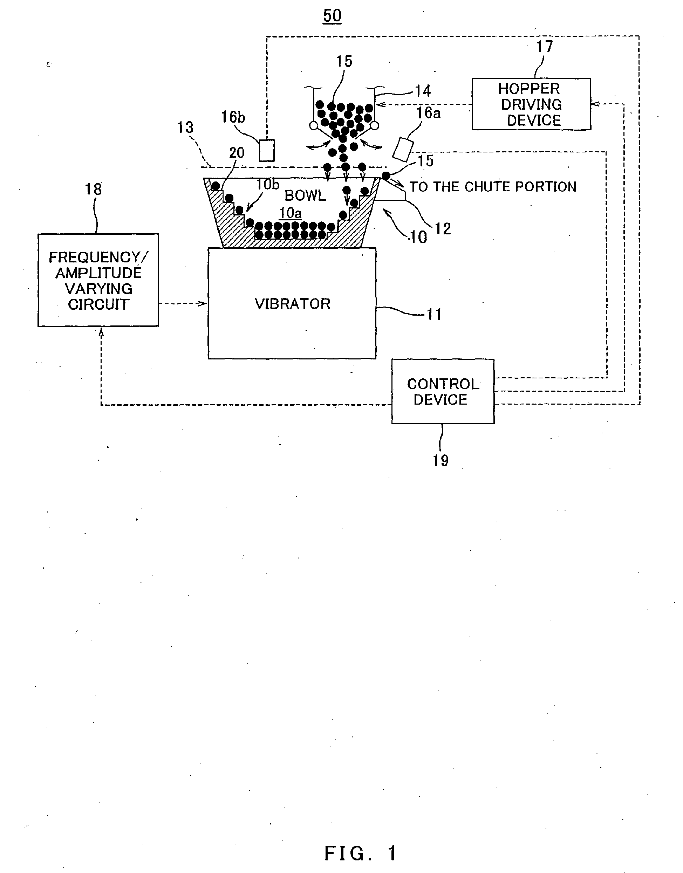

Referring first to FIG. 1, description will be made of the configuration of a vibrating bowl feeder.

FIG. 1 is a schematic illustration showing the configuration of a vibrating bowl feeder according to an embodiment of the present invention.

As shown in FIG. 1, the vibrating bowl feeder 50 (i.e., material feeder) includes, a vibrating bowl 10, vibrator 11, hopper 14 and control device 19, as standard components thereof.

The vibrator 11 comprises, for example, an electromagnet (not shown) and plural (three) leaf springs (not shown). Driving power generated by ON/OFF of the electromagnet is amplified by utilizing the leaf springs to vibrate the vibrating bowl 10. The electromagnet may be replaced with a piezoelectric element.

Vibration of the vibrating bowl 10 generated by the vibrator 11 is imparted with directionality by appropriate positional adjustment of the leaf springs, thereby making it possible to feed objects 15 on a feed passage 20 (to be described later) formed internally of a concave portion 10a of the vibrating bowl 10 in a fixed direction.

Since the vibrator 11 used in the present embodiment is based on the conventional art, more detailed description of the vibrator 11 is omitted herein.

The vibrating bowl 10 serves to feed the objects 15 along the feed passage 20 by inching the objects 15 located inside the vibrating bowl 10 by means of vibration applied by the vibrator 11.

The vibrating bowl 10 can be conceived to have a shape selected from various shapes including a substantially hemispherical shape (mortar-like shape), cylindrical shape and conical shape. The vibrating bowl 10 employed in this embodiment has a mortar-like shape having increasing diameter as it extend from the bottom toward the top.

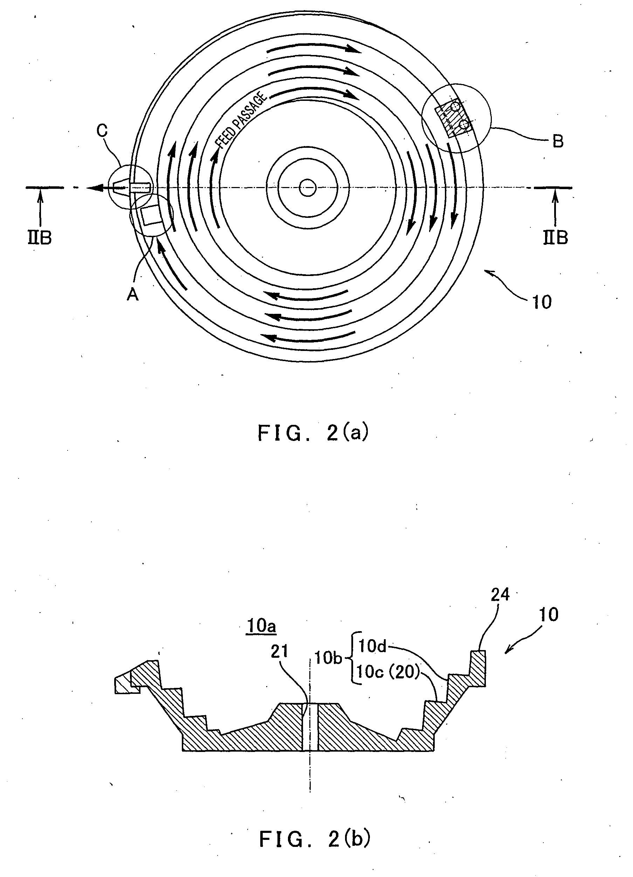

The vibrating bowl 10 is internally formed with semicircular stepped concave portion 10a provided with steps 10b on the inner peripheral wall of the vibrating bowl 10. The bottom surface of each step 10b functions as the feed passage 20. The structure of the concave portion 10a will be described in detail later with reference to FIG. 2.

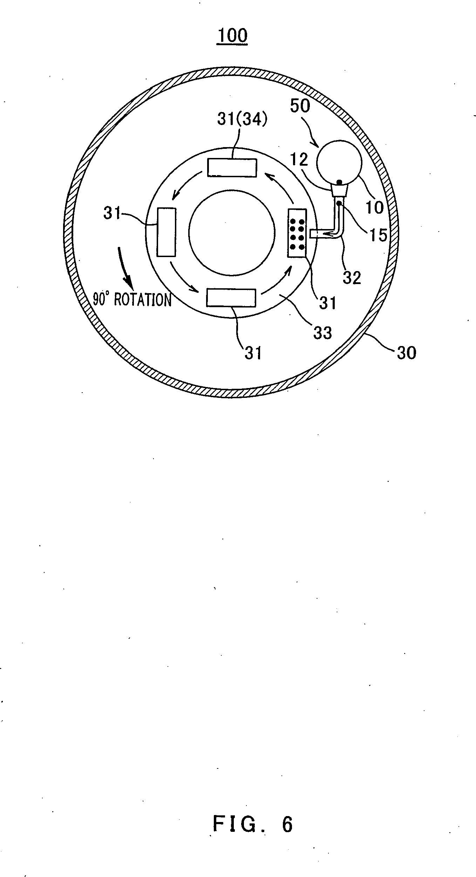

The vibrating bowl 10 is provided with a guide member 12 at an appropriate outer peripheral surface of the sidewall of the vibrating bowl 10 for guiding the objects 15 ejected from the vibrating bowl 10 to a chute portion 32 (see FIG. 6). More exactly, the guide member 12 is located on a portion of the sidewall that coincides with the termination of the feed passage 20.

The hopper 14 is positioned above the vibrating bowl 10 (concave portion 10a) so as to face the opening of the concave portion 10a. The hopper 14 serves as an auxiliary tank for temporarily reserving therein collectivity of objects 15 in a larger quantity than predetermined.

When the collectivity of objects 15 is collectivity of granular metal balls 15 each having a diameter of about 1.5 mm, a reticulate member 13 having multiple openings each having a dimension larger than the diameter of each metal ball 15 and smaller than a value twice as large as the diameter of each metal ball 16 may be inserted in the gap defined between the hopper 14 and the vibrating bowl 10.

The reticulate member 13 can sift the metal balls 15 properly to prevent a metal ball having a nonconforming size or a metal mass comprising plural metal balls joined fixedly to each other from entering the concave portion 10a.

If the reticulate member 13 is attached to the sidewall of the vibrating bowl 10 so as to cover the entire opening of the vibrating bowl 10, vibration transferred from the vibrating bowl 10 to the reticulate member 13 can advantageously enhance the sifting effect of the reticulate member 13 exerted on the metal balls 15.

The control device 19 comprises a microprocessor configured to control the object vibrating and feeding operation of the vibrating bowl 10 vibrated by the vibrating bowl feeder 50.

Input sensors connected to the control device 19 include a first optical sensor 16a (number detecting means) capable of counting the number of objects 15 ejected from the vibrating bowl 10, the first optical sensor 16a comprising a fiber-shaped light-emitting portion (not shown) and a fiber-shaped light-receiving portion (not shown), and a second optical sensor 16b (level detecting means) capable of detecting the uppermost height level of collectivity of objects 15 collected in the concave portion 10a, the second optical sensor 16b comprising a fiber-shaped light-emitting portion (not shown) and a fiber-shaped light-receiving portion (not shown).

The first optical sensor 16a may be either an optical sensor of the reflection-type having the light-emitting portion and light-receiving portion formed integral with each other or an optical sensor of the transmission-type having the light-emitting portion and light-receiving portion separately. An optical sensor of the reflection-type is more preferable than the optical sensor of the transmission type because the reflection-type optical sensor allows the required parts count to be lowered. An optical sensor of the reflection type is used as the second optical sensor 16b.

The second optical sensor 16b has a detection window (not shown) facing a portion in the vicinity of the center of the concave portion 10a to obtain position data on the uppermost height level of the collectivity of objects 15, based on which the total quantity of the collectivity of the objects 15 collected within the concave portion 10a of the vibrating bowl 10 can be estimated.

Instead of (or together with) the second optical sensor 16b, it is possible to provide either a marking (not shown), such as calibration, inside the concave portion 10a (for example, on the inner wall of the concave portion 10a) or an appropriate post member (not shown) provided with the marking inside the concave portion 10a, for allowing an operator to check the total quantity of the collectivity of objects 15 collected within the concave portion 10a.

Components to be controlled by the control device 19 include a hopper driving device 17 for causing the object supply door of the hopper 14 to open or close, and a frequency/amplitude varying circuit 18 (for example an inverter circuit) configured to vary the frequency or amplitude of a vibration signal to be fed to an electromagnetic coil incorporated in the vibrator 11.

By using the input sensors connected to the control device 19 and the components to be controlled by the control device 19, the control device 19 can adjust the object vibrating and feeding ability of the vibrating bowl 10 by appropriately varying the frequency or amplitude of a vibration signal to be fed to the vibrator 11 (electromagnetic coil) by means of the frequency/amplitude varying circuit 18 based on number data on the objects 15 obtained by the first optical sensor 16a when, for example, a change in load occurs such as to vary the total quantity of the collectivity of objects 15 accommodated within the vibrating bowl 10.

That is, even when a change in load occurs such as to vary the total quantity of the collectivity of objects 15 accommodated within the vibrating bowl 10, the control device 19 is capable of appropriately varying the frequency or amplitude of the vibration signal to be fed to the vibrator 11 (electromagnetic coil) by means of the frequency/amplitude varying circuit 18 so as to keep constant the number of objects 15 to be ejected outside of the concave portion 10a of the vibrating bowl 10 per unit time.

Also, the control device 19 is capable of appropriately adjusting the supply of objects 15 from the hopper 14 into the concave portion 10a by controlling the opening/closing timing for the object supply door of the hopper 14 by means of the hopper driving device 17 while monitoring the quantity of the collectivity of objects 15 in the concave portion 10a based on the cumulative quantity of objects 15 determined from number data items obtained by the first optical sensor 16a and the uppermost height level of the collectivity of objects 15 stored in the concave portion 10a determined from position data obtained by the second optical sensor 16b.

In a certain embodiment, for example, the control device 19 simply causes the object supply door of the hopper 14 to open or close just before the collectivity of objects 15 within the concave portion 10a runs out by referencing position data obtained by the second optical sensor 16b. This embodiment simplifies the control over the opening/closing operation of the door of the hopper 14. In another embodiment, the control device 19 compares the total quantity of objects 15 previously loaded into the concave portion 10a and the cumulative quantity of ejected objects 15 detected by the first optical sensor 16a and then causes the object supply door of the hopper 14 to open or close before the cumulative quantity of ejected objects 15 becomes equal to the total quantity of objects 15 loaded into the concave portion 10a. This embodiment simplifies the control over the opening/closing operation of the door of the hopper 14.

The "control device", as used in the present DESCRIPTION, is meant to include not only a single control device but also a group of control devices configured to cooperate with each other in order to control the operation of the vibrating bowl feeder 50. Therefore, the control device 19 need not necessarily comprise a single control device, but may comprise plural control devices distributed to cooperate with each other in controlling the operation of the vibrating bowl feeder 50. As will be described later, in cases where the vibrating bowl feeder 50 is located inside the vacuum chamber of a vacuum deposition system 100 (see FIG. 6), the control device 19 described here may be configured to function also as a control device (not shown) for controlling the operation of the vacuum deposition system 100.

With reference to the drawings, details of the structure of the vibrating bowl 10 will be described below.

One illustrative structure of the vibrating bowl 10 will be explained in detail as follows, using metal balls 15 each having a diameter of about 1.5 mm as an example of the objects 15 to be fed.

FIGs. 2 to 5 are each a view illustrating the internal structure of a vibrating bowl.

FIG. 2(a) is a plan view of the vibrating bowl as viewed from above the concave portion; and FIG. 2(b) is a sectional view taken along line IIB-IIB of FIG. 2(a).

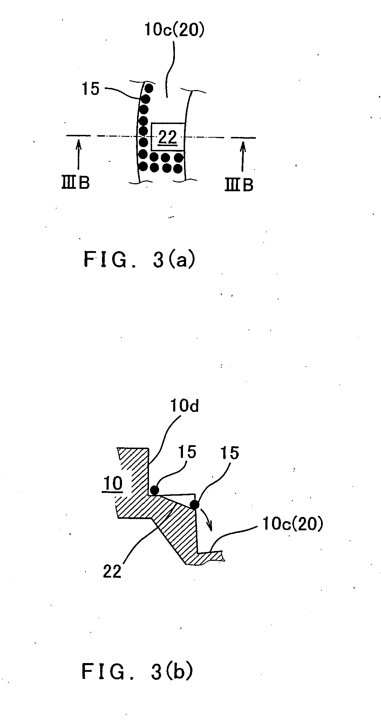

FIG. 3(a) is an enlarged plan view of a portion A shown in FIG. 2(a); and FIG. 3(b) is a sectional view taken along line IIIB-IIIB of FIG. 3(a).

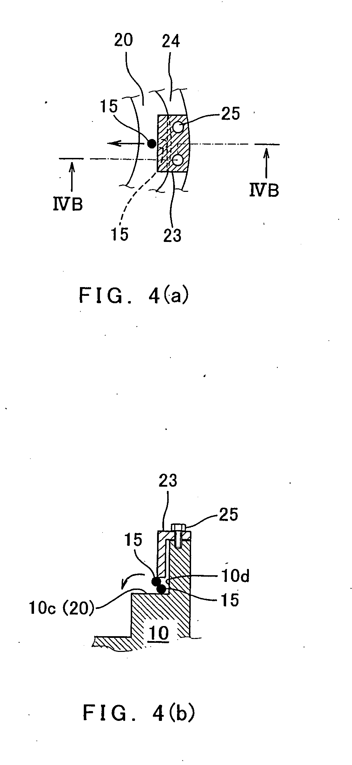

FIG. 4(a) is an enlarged plan view of a portion B shown in FIG. 2(a); and FIG. 4(b) is a sectional view taken along line IVB-IVB of FIG. 4(a).

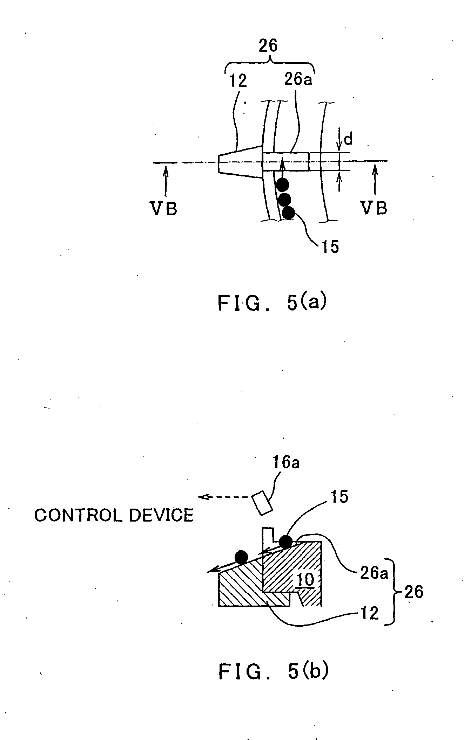

FIG. 5(a) is an enlarged plan view of a portion C shown in FIG. 2(a); and FIG. 5(b) is a sectional view taken along line VB-VB of FIG. 5(a).

Referring to FIG. 2, the vibrating bowl 10 defines a through-hole 21 extending substantially centrally thereof for allowing a non-illustrated fixing member (for example a bolt) to be inserted therethrough for fixing the vibrating bowl 10 to the vibrator 11 (see FIG. 1).

By inserting the fixing member into the through-hole 21 or removing the fixing member from the through-hole 21, it is possible to mount the vibrating bowl 10 on or remove it from the vibrating bowl feeder 50 easily. Thus, a maintenance operation for cleaning dust or the like accumulated in the vibrating bowl 10 can be facilitated.

As shown in FIG. 2(b), the concave portion 10a of the vibrating bowl 10 is formed with a step 10b extending helically (circumferentially of the vibrating bowl 10) from a central portion toward a peripheral portion along the inner peripheral wall of the concave portion 10a with an upward slope.

As the vibrating bowl 10 vibrates metal balls 15 on a bottom surface 10c of the step 10b, the metal balls 15 creep up in a direction (upward direction) opposite to the sliding direction of the slope.

That is, the bottom surface 10c of the step 10b functions as the feed passage 20 capable of feeding the metal balls 15, as indicated by arrows in FIG. 2(a). A side surface 10d of the step 10b serves as a guide portion in feeding the metal balls 15 on the feed passage 20.

The bottom surface 10c as the feed passage 20 is downwardly inclined in a widthwise direction from the inner edge toward the outer edge. This feature allows the metal balls 15 on the feed passage 20 (i.e., bottom surface 10c) to move toward the side surface 10d by their own weights. Thus, the side surface 10d can exercise the guiding function reliably in feeding the metal balls 15.

As can be seen from FIGs. 2 and 3, the feed passage 20 is provided at an appropriate intermediate point with a cutout groove 22 formed by cutting out a portion of the feed passage 20 widthwise thereof in a downwardly oblique direction so as to leave a remaining portion having a predetermined width from the side surface 10d which is, for example, substantially equal to the diameter of each metal ball 50.

The cutout groove 22 causes metal balls 15 collected in plural rows to drop along the slope of the cutout groove 22 by their own weights while retaining only one row of metal balls 15 on the feed passage 20.

Thus, the cutout groove 22 causes the collectivity of metal balls 15 in plural rows to be aligned into a single row of metal balls 15 in contact with the side surface 10d of the step 10b and then allows only this row of metal balls 15 to pass by the cutout groove 22 and advance into downstream-side feed passage 20 that extends downstream of the cutout groove 22, as shown in FIG. 3(a).

In this way, the cutout groove 22 functions to align the plural rows of collected metal balls 15 into a single row simply and easily. As a result, the number of metal balls 15 to be ejected outside of the vibrating bowl 10 at a time can be limited properly. (Actually, the number of metal balls 15 is limited to one at a time by a combined aligning effect exercised by the cutout groove 22 and a fragment member 23 to be described later.) Thus, it is possible to estimate the total number of metal balls 15 ejected outside of the concave portion 10a of the vibrating bowl 10 during a predetermined time by means of the first optical sensor 16a, as will be described later.

A plurality of such cutout grooves 22 may be located at intermediate points on the feed passage 20 to exercise the effect of aligning collectivity of metal balls 15 more reliably.

The cutout groove 22 is preferably located adjacent to the termination, in particular, of the feed passage 20 because the provision of the cutout groove 22 at that location can ensure the condition of metal balls 15 aligned in a single row in ejecting the metal balls 15 outside of the concave portion 10a.

As can be seen from FIGs. 2 and 4, at an appropriate intermediate point on the feed passage 20, an L-shaped fragment member 23 is located in contact with the side surface 10d of the step 10b. The fragment member 23 extends upwardly from a location spaced a predetermined distance apart from the feed surface (i.e., bottom surface 10c of the step 10b) of the feed passage 20 as a reference surface and is then bent about 90° to extend parallel with the bottom surface 10c. For example, the aforementioned predetermined distance is larger than the diameter of each metal ball 15 and smaller than a value twice as large as that diameter.

The portion of the fragment member 23 that extends parallel with the bottom surface 10c is fixed to a rim ridge 24 (see FIG. 2) circumscribing the region of the concave portion 10a with bolts 25.

A lower end portion of the fragment member 23 interferes with metal balls 15 collected in plural tiers to cause metal balls 15 to drop by their own weights while allowing only one tier of metal balls 15 to be retained on the feed passage 20, as shown in FIG. 4(b).

Thus, the fragment member 23 causes the collectivity of metal balls 15 in plural tiers to be aligned into a single tier of metal balls 15 in direct contact with the bottom surface 10c of the step 10b and then allows only this tier of metal balls 15 to pass under the fragment member 23 and advance into downstream-side feed passage 20 that extends downstream of the fragment member 23.

In this way, the fragment member 23 functions to align the plural tiers of metal balls 15 into a single tier simply and easily. As a result, the number of metal balls 15 to be ejected outside of the vibrating bowl 10 at a time can be limited properly. Actually, the number of metal balls 15 is limited to one at a time by the combined aligning effect exercised by the fragment member 23 and the cutout groove 22. Thus, it is possible to estimate the total number of metal balls 15 ejected outside of the concave portion 10a of the vibrating bowl 10 during a predetermined time by the first optical sensor 16a, as will be described later.

A plurality of such fragment members 23 may be located at intermediate points on the feed passage 20 to exercise the effect of aligning collectivity of metal balls 15 more reliably.

The fragment member 23 is preferably located adjacent to the termination, in particular, of the feed passage 20 because the provision of the fragment member 23 at that location can ensure the condition of metal balls 15 aligned in a single tier in ejecting the metal balls 15 outside of the concave portion 10a.

As can be seen from FIGs. 2 and 5, the feed passage 20 is provided at its termination with a step portion 26. The step portion 26 is configured to cause metal balls 15 that are present in the vicinity of the termination to be ejected outside of the concave portion 10a in a direction substantially perpendicular and downwardly oblique to the feed direction in which the metal balls 15 are fed on the feed passage 20.

More specifically, the step portion 26 comprises a cut slope 26a formed by cutting out a terminating portion of the feed passage 20 widthwise and downwardly obliquely, and a guide member 12, as shown in FIG. 5. Here, the guide member 12 is joined integrally with the vibrating bowl 10 by appropriate fixing means (not shown) so as to be capable of vibrating together with the vibrating bowl 10, as shown in FIG.5(b).

The guide member 12 serves to guide metal balls 15 having passed through the cut slope 26a to the chute portion 32 (see FIG. 6). The guide member 12 has a slope which is continuous with the lower end of the cut slope 26a and is inclined at an angle equal to the angle of inclination of the cut slope 26a. Thus, the guide member 12 enables metal balls 15 passing through the cut slope 26a to move from the cut slope 26a toward the chute portion 32 smoothly.

The cut slope 26a has a width d adjusted so as to be larger than the diameter of each metal ball 15 and smaller than a value twice as large as that diameter. This feature makes it possible to prevent a nonconforming metal ball 15 comprising plural metal balls joined to each other and an elongate impurity, each of which is longer than the width d of the cut slope 26a, from entering the metal ball ejection passage advantageously.

Further, the foregoing first optical sensor 16a of the reflection type is positioned so as to be capable of counting the number of metal balls 15 passing through the step portion 26 after ejection from the feed passage 20. That is, the detection window of the first optical sensor 16a faces the cut slope 26a.

More specifically, an upper limit position of the first optical sensor 16a is a position just above a point on the cut slope 26a that lies on an extension of the feed direction in which metal balls 15 that are present in the vicinity of the termination of the feed passage 20 are fed. More desirably, the upper limit position of the first optical sensor 16a is a position just above a point on the cut slope 26a that departs from the extension of the feed direction by a distance equal to the diameter of one metal ball 15 downwardly along the cut slope 26a. The first optical sensor 16a thus positioned is capable of detecting metal balls 15 each having a minimum velocity component along the inclination of the cut slope 26a and hence can advantageously avoid erroneous detection of any metal ball 15 that has not been properly ejected to the cut slope 26a.

A lower limit position of the first optical sensor 16a is a position just above a point on the cut slope 26a (or the guide member 12) which a preceding metal ball 15 reaches by moving on the cut slope 26a during a time difference between a point in time at which the preceding metal ball 15 is ejected to the cut slope 26a and a point in time at which the succeeding metal ball 15 is ejected to the cut slope 26a. With this arrangement, the succeeding metal ball 15 is not ejected to the cut slope 26a subsequently to the preceding metal ball 15 until the preceding metal ball 15 is detected by the first optical sensor 16a. For this reason, the total number of metal balls 15 ejected outside of the concave portion 10a can be made equal to the total number of metal balls 15 based on number data obtained by the first optical sensor 16a and, hence, a difference in number between the two does not occur.

Since the detection window of the first optical sensor 16a is positioned to face the cut slope 26a in order to avoid interference with any other member properly, the maintenance operation of the vibrating bowl feeder 50 can be improved from the viewpoint of easy mounting and removal of the first optical sensor 16a and the like.

The step portion 26 thus formed realizes a perpendicularly ejecting technique for ejecting metal balls 15 outside of the concave portion 10a in a direction perpendicular to the feed direction in which metal balls 15 present in the vicinity of the termination of the feed passage 20 are fed. With this perpendicularly ejecting technique employed, even under the condition that the metal balls 15 are fed contiguously with each other, the metal ball feed direction is changed to a direction substantially perpendicular thereto by the step portion 26 and such a change in the feed direction provides appropriate spacing between adjacent ones of the metal balls 15 passing through the step portion 26. For this reason, it is possible to avoid plural metal balls 15 being fed contiguously with each other on the step portion 26 and on a feed passage extending downstream of the step portion 26 and, as a result, the first optical sensor 16a becomes able to detect the number of metal balls 15 ejected outside of the vibrating bowl 10 reliably.

Even when the vibrating and feeding ability of the vibrating bowl 10 with respect to metal balls 15 differs from a set value, the moving speed of each metal ball 15 on the step portion 26 is determined from the angle of inclination of the cut slope 26a inclined downwardly and the metal ball's own weight, which makes it easy to control the number of metal balls 15 passing through the step portion 26 per unit time. Also, the first optical sensor 16a becomes able to count the number of metal balls 15 ejected outside of the concave portion 10a of the vibrating bowl 10 accurately.

As described above, the first optical sensor 16a is positioned just above a point on the cut slope 26a that lies on an extension of the feed direction in which metal balls 15 that are present in the vicinity of the termination of the feed passage 20 are fed, more desirably, just above a point on the cut slope 26a that departs from the extension of the feed direction by a distance equal to the diameter of one metal ball 15 downwardly along the cut slope 26a. The first optical sensor 16a thus positioned is preferable because a difference does not occur between the total number of metal balls 15 ejected outside of the concave portion 10a and the total number of metal balls 15 based on number data obtained by the first optical sensor 16a.

Further, collectivity of metal balls 15 present in the vicinity of the termination of the feed passage 20 can be aligned into a single row and tier simply and easily by the aforementioned aligning effect exercised by the cutout groove 22 and the fragment member 23. Accordingly, the metal balls 15 can be ejected one by one through a zone coinciding with the detection window of the first optical sensor 16a. Thus, the first optical sensor 16a, with the help of the cutout groove 22 and fragment member 23 exercising the aligning effect, can detect the number of metal balls 15 ejected outside of the concave portion 10a reliably without a number detection error.

Referring to FIG. 6, the configuration and operation of a vacuum deposition system as one example to which the above-described vibrating bowl feeder 50 is applied will be explained. This vacuum deposition system is configured to vapor-deposit a film on a substrate using metal balls 15 ejected from the vibrating bowl feeder 50 as a film forming material for deposition.

First, description is directed to the internal structure of a vacuum deposition system 100.

FIG. 6 is a schematic illustration showing the internal structure of the vacuum deposition system according to an embodiment of the present invention.

The vacuum deposition system 100 includes: a cylindrical vacuum chamber 30 having a bottom portion and a lid portion, the vacuum chamber 30 allowing its internal pressure to be reduced; an annular disc-shaped turret 33 mounted on the bottom portion of the vacuum chamber 30 for rotation relative to the bottom portion; four vessels 31, such as boats for resistance heating, mounted on the turret 33 so as to be spaced from each other by about 90° circumferentially of the turret 33, each of the vessels 31 being a final destination of supply of metal balls 15; a single vibrating bowl feeder 50 located at a suitable place within the vacuum chamber 30 for feeding the vessels 31 with metal balls 15; a chute portion 32 for leading metal balls 15 ejected outside of the vibrating bowl 10 (i.e., the concave portion 10a of the vibrating bowl 10) of the vibrating bowl feeder 50 through the guide member 12 to each vessel 31; and non-illustrated heating means (for example, heating means of the resistance heating type for heating metal balls through a boat as vessel 31) for heating and evaporating metal balls 15 loaded on each vessel 31 at an evaporating site 34. It is needless to say that the heating means described here is not limited to the resistance heating device but may be an electron beam heating device.

In FIG. 6, the vibrating bowl 50 and the guide member 12 are shown to represent the vibrating bowl feeder 50.

The vacuum deposition operation of the vacuum deposition system 100 on a substrate (not shown) will be described with reference to FIG. 6.

With the internal pressure of the vacuum chamber 30 reduced to a predetermined degree of vacuum by non-illustrated appropriate evacuation means (vacuum pump or the like), the vibrating bowl feeder 50 is actuated to vibrate and feed metal balls 15 in the vibrating bowl 10.

The vibrating bowl 10 vibrates to cause the metal balls 15 to creep up helically along the feed passage 20 (see FIG. 2) formed on the inner peripheral wall of the concave portion 10a, while the cutout groove 22 (see FIG. 3) and the fragment member 23 (see FIG. 4) cause the metal balls 15 to be aligned into a single row and tier. The metal balls 15 thus aligned are ejected outside of the concave portion 10a, while the first optical sensor 16a detects the number of metal balls 15 moving on the cut slope 26a (see FIG. 5) of the step portion 20 formed at the termination of the feed passage 20.

The metal balls 15 thus ejected outside of the concave portion 10a moves one by one through the guide member 12 and the chute portion 32 and are then loaded on one vessel 31.

When the number of metal balls 13 loaded on the vessel 31 reaches a predetermined number (for example 10), the operation of the vibrating bowl feeder 50 is stopped (by stopping feeding a vibration signal to the vibrator 11) to stop loading metal balls 15 on the vessel 31.

Subsequently, the turret 33 is rotated 90° counterclockwise to move the vessel 31 loaded with the predetermined number of metal balls 15 from the metal ball supplying site at which the vibrating bowl feeder 50 located inside the vacuum chamber 30 supplies the vessel 31 with metal balls 15 to the metal ball evaporating site 34.

With the vessel 31 in this condition, the appropriate heating means heats the metal balls 15 to evaporate them. The deposition material evaporated from the metal balls 15 scatters toward the substrate placed inside the vacuum chamber 30 to form a deposition material film on the surface of the substrate.

At the time the metal balls 15 loaded on the vessel 31 are completely evaporated from the vessel 31, heating of the metal balls 15 by the heating means is stopped to complete one vacuum deposition cycle of the vacuum deposition system 100 in which all the metal balls on the vessel 31 are evaporated onto the substrate. When necessary, the same vacuum deposition operation is repeated with the turret 33 further rotated.

With this vacuum deposition system 100, the vibrating bowl feeder 50 is capable of supplying vessel 31 with a predetermined number (for example 10) of metal balls 15 as the film forming material for deposition within the vacuum chamber 30. Therefore, the thickness of a film deposited on the substrate surface by vacuum deposition in the vacuum deposition system 100 can be easily and precisely controlled by control of the weight or volume per metal ball 15.

The vacuum deposition system 100 is capable of easily varying the total number of metal balls 15. to be supplied to vessel 31, thereby making it possible to quickly accommodate to a change in the deposited film thickness required of a product to be subjected to vacuum deposition by the vacuum deposition system 100.

By rotation of the turret 33 carrying plural vessels 31 thereon, it is possible to move the vessels 31 one after another from the metal ball supplying site to the metal ball evaporating site 34, thereby to form a continuous deposition mechanism of the vacuum deposition system 100.

### Variation

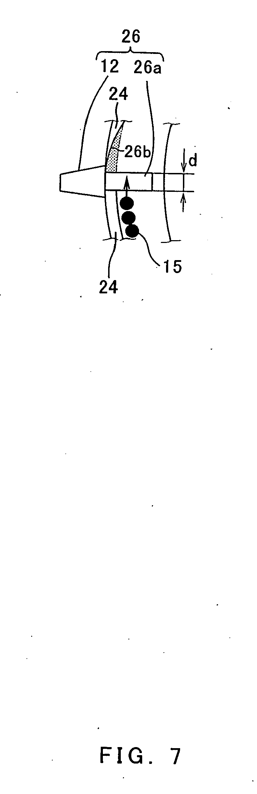

FIG. 7 is an enlarged plan view showing a variation of the structure of portion C shown in FIG. 2 for illustrating one variation of the present embodiment.

Referring to FIG. 7, the vibrating bowl 10 has the rim ridge 24 extending on the opposite sides of the step portion 26 (see FIG. 2). A portion of the rim edge 24 that is located far from the metal balls 15 is cut out obliquely to form a predetermined slanting surface 26b extending from a side edge of the cut slope 26a along the outer peripheral surface of a portion of the rim edge 24 that is located near the metal balls 15. The cutout portion is shaded in the figure.
This slanting surface 26b prevents a nonconforming metal ball 15 comprising plural balls fixedly joined with each other or an elongate impurity, each of which is longer than the width d of the cut slope 26a, from coming back toward the cut slope 26a by colliding with the portion of the rim ridge 24 that is located on the far side when the nonconforming metal ball or elongate impurity passes across the step portion 16, thus facilitating the passage of the nonconforming metal ball 15 or the like across the step portion 26.

It will be apparent from the foregoing description that many improvements and other embodiments of the present invention may occur to those skilled in the art. Therefore, the foregoing description should be construed as an illustration only and is provided for the purpose of teaching the best mode for carrying out the present invention to those skilled in the art. The details of the structure and/or the function of the present invention can be modified substantially without departing from the spirit of the present invention.

### Industrial Applicability

The vibrating bowl feeder according to the present invention is capable of accurately controlling the number of objects to be fed in ejecting the objects outside of the vibrating bowl by vibrating the objects by using the vibrating bowl. The vibrating bowl feeder is useful as a device feeding material at a constant rate for use in, for example, a vacuum deposition system configured to deposit a film on a substrate surface.

## Claims

1. A vibrating bowl comprising:
a concave portion capable of storing therein collectivity of objects to be fed;
a feed passage capable of feeding the objects within the concave portion by vibrating the objects; and
a step portion configured to cause the objects to be ejected outside of the concave portion in a direction substantially perpendicular and downwardly oblique to a feed direction in which the objects which are present in the vicinity of a termination of the feed passage are fed.

2. The vibrating bowl according to claim 1, wherein the step portion has a cut slope formed by cutting out a portion of the feed passage widthwise and downwardly.

3. A vibrating bowl comprising:
a concave portion capable of storing therein collectivity of objects to be fed;
a feed passage capable of feeding the objects within the concave portion by vibrating the objects;
a step portion configured to cause the objects which are present in the vicinity of a termination of the feed passage to be ejected outside of the concave portion in a downwardly oblique direction; and
number detecting means facing the step portion for counting a number of the objects which are being fed on the step portion.

4. The vibrating bowl according to claim 3, wherein the step portion has a cut slope formed by cutting out a portion of the feed passage widthwise and downwardly, and the number detecting means has a detection window facing the cut slope.

5. The vibrating bowl according to claim 2 or 4, wherein each of the objects is substantially spherical, and the cut slope has a width larger than a diameter of each object and smaller than a value twice as large as the diameter of each object.

6. A vibrating bowl comprising:
a concave portion capable of storing therein collectivity of objects to be fed;
a feed passage capable of feeding the objects within the concave portion by vibrating the objects; and
a cutout groove for aligning plural rows of collected objects that are present at an intermediate point on the feed passage into a single row widthwise of the feed passage, the cutout groove being formed by cutting out a portion of the feed passage widthwise so as to leave a remaining portion having a predetermined width.

7. The vibrating bowl according to claim 6, wherein each of the objects is substantially spherical, and the predetermined width is substantially equal to a,diameter of each object.

8. The vibrating bowl according to claim 6, wherein the cutout groove is located adjacent to a termination of the feed passage.

9. A vibrating bowl comprising:
a concave portion capable of storing therein collectivity of objects to be fed;
a feed passage capable of feeding the objects within the concave portion by vibrating the objects; and
a fragment member extending upwardly from a location spaced a predetermined distance apart from a feed surface of the feed passage as a reference surface, for aligning plural tiers of collected objects that are present at an intermediate point on the feed passage into a single tier.

10. The vibrating bowl according to claim 9, wherein each of the objects is substantially spherical, and the predetermined distance is larger than a diameter of each object and smaller than a value twice as large as the diameter of each object.

11. The vibrating bowl according to any one of claims 1 to 10, wherein the concave portion has an inner wall provided with a predetermined marking.

12. A vibrating bowl feeder comprising a vibrator supporting the vibrating bowl as recited in any one of claims 1 to 11 for vibrating the vibrating bowl, wherein
the objects on the feed passage are capable of being fed by vibration of the vibrating bowl caused by the vibrator.

13. The vibrating bowl feeder according to claim 12, wherein the concave portion is provided with a reticulate member for covering an opening of the concave portion.

14. The vibrating bowl feeder according to claim 12, further comprising: a hopper located above the opening of the concave portion of the vibrating bowl, for reserving collectivity of objects therein; a level detecting means, for detecting an uppermost height level of the collectivity of objects stored in the concave portion; and a control device configured to control an object supply operation of the hopper based on position data obtained from the level detecting means so as to adjust supply of the objects from the hopper to the concave portion.

15. A vibrating bowl feeder comprising: a vibrator supporting the vibrating bowl as recited in claim 3 or 4 for vibrating the vibrating bowl; number detecting means configured to count a number of objects being fed on the step portion; and a control device configured to control a frequency or amplitude of a vibration signal to be fed to vibrator based on number data obtained by the number detecting means so as to adjust an object vibrating and feeding ability of the vibrating bowl.

16. The vibrating bowl feeder according to claim 15, wherein the control device is configured to control the frequency or amplitude of the signal so as to keep constant a number of objects fed per unit time obtained by the number detecting means.

17. A vacuum deposition system comprising: a vacuum chamber of which internal pressure is reducible; the vibrating bowl feeder as recited in any one of claims 12 to 16 which is located inside the vacuum chamber; a vessel capable of being loaded with objects ejected outside of the vibrating bowl feeder as a film forming material; and heating means capable of heating the film forming material comprising the objects, wherein
the film forming material is heated by the heating means and is vapor-deposited on a substrate placed inside the vacuum chamber under a reduced internal pressure.
